# EUROPEAN PATENT APPLICATION

(11) **EP 4 590 088 A2**
(43) Date of publication of application: **23.07.2025**
(21) Application number: 24220368.5
(22) Date of filing: 16.12.2024
(51) Int. Cl.: H10D 84/03, H10D 84/83, H10D 84/85, H10D 88/00, H10D 30/01, H10D 30/00, H10D 30/67, H10D 64/27, H10D 62/832, H10D 1/47, H10D 84/80

(54) **HV TRANSISTORS & RESISTORS FOR STACKED TRANSISTOR ARCHITECTURES**

(30) Priority: 29.12.2023 US 202318400771
(71) Applicant: Intel Corporation, Santa Clara, CA 95054 (US)
(72) Inventor: RAMASWAMY, Rahul, Portland, 97229 (US); RADOSAVLJEVIC, Marko, Portland, 97229 (US); HAFEZ, Walid, Portland, 97229 (US); CHANG, Hsu-Yu, Hillsboro, 97124 (US); MOKLER, Scott, Hillsboro, 97124 (US)
(74) Representative: 2SPL Patentanwälte PartG mbB

(57) **Abstract**

A material stack comprising a plurality of bi-layers, each bi-layer comprising two semiconductor material layers, is fabricated into both a low voltage transistor structure and a high voltage transistor structure. Within the low voltage transistor structure, a first of two semiconductor material layers may be replaced with a gate stack while the high voltage transistor structure may retain both of two semiconductor material layers. The material stack may also be fabricated into both a transistor structure and a resistor structure. Within the transistor structure, a first of two semiconductor material layers may be replaced with a gate stack while the resistor structure may retain both of two semiconductor material layers.

## Description

### BACKGROUND

Advanced integrated circuits (ICs) are transitioning to stacked transistor structures comprising a vertical stack of a plurality of nanoribbon or wire (RoW) channels. Some stacked transistor structures comprise complementary field effect transistors (CFETs). In CFET technology, channel material may be the same (e.g., Si) in both NMOS and PMOS portions of a stack. Channel material may also be varied, for example utilizing silicon for NMOS RoW channels and germanium or SiGe for PMOS RoW channels.

Regardless of the specific transistor structure, stacked transistor architectures all pose new challenges to the integration of high voltage (HV) transistors with low voltage (LV) transistors. Typically, low voltage transistors suitable for logic devices are unable to sustain high voltages, and will suffer electrical breakdown. Relative to LV transistors, HV transistors may rely on thicker gate dielectric as well as a greater channel width to enable higher voltage operating points. Such structural attributes are more challenging to achieve within stacked transistor architectures. For example, a transistor material stack optimal for LV transistors may have insufficient vertical spacing between RoW channels for gate dielectric to be significantly thicker. Transistor architectures optimal for LV applications may also result in RoW channels of insufficient width for HV applications. The ability to fabricate both LV and HV stacked transistors would therefore be commercially advantageous.

Stacked transistor architectures may also pose new challenge for the integration of thin film resistors. For example, it is more difficult to fabricate resistors utilizing a thin film of polysilicon and/or titanium nitride (TiN) within a frontend process flow made more complex by stacked transistor fabrication. It would therefore also be advantageous to reduce the fabrication overhead and/or IC die footprint associated with such resistor structures.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements. Further, where considered appropriate, reference labels have been repeated among the figures to indicate corresponding or analogous elements. In the figures:
FIG. 1 is an isometric illustration of a portion of an IC that includes a LV stacked transistor structure and a HV stacked transistor structure, in accordance with some embodiments;
FIG. 2 is a flow diagram illustrating methods for forming a HV stacked transistor structure compatible with LV stacked transistor structures, in accordance with some embodiments;
FIG. 3A and 3B illustrate cross-sectional views through orthogonal planes of both LV and HV transistor structures, in accordance with some embodiments;
FIG. 4, 5, 6, 7, 8, 9, 10, 11, 12 and 13 illustrate cross-sectional views through one plane of LV and HV transistor structures, in accordance with some embodiments of the methods illustrated in FIG. 2;
FIG. 14 is an isometric illustration of a portion of an IC that includes a LV stacked transistor structure and a stacked resistor structure, in accordance with some embodiments;
FIG. 15 is a flow diagram illustrating methods for forming a stacked resistor structure compatible with LV and/or HV stacked transistor structures, in accordance with some embodiments;
FIG. 16, 17 18 and 19 illustrate cross-sectional views through one plane of an LV transistor structure and a resistor structure, in accordance with some embodiments of the methods illustrated in FIG. 15;
FIG. 20 illustrates a mobile computing platform and a data server machine employing an IC with LV and HV stacked transistor structures and/or stacked resistor structures, in accordance with some embodiments; and
FIG. 21 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of systems and applications other than what is described in detail herein.

Reference is made in the following detailed description to the accompanying drawings, which form a part hereof and illustrate exemplary embodiments. Furthermore, structural and/or logical changes may be made without departing from the scope of claimed subject matter. Directions and directional references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of' or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

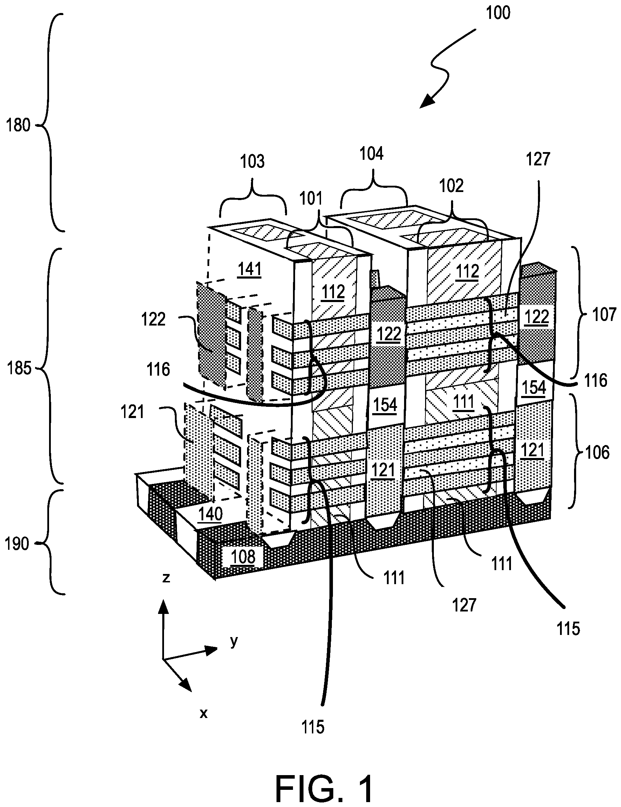

FIG. 1 is an isometric illustration of an integrated circuit (IC) portion 100 comprising stacked transistor structures 101, 102, 103 and 104 within a device layer 185 that is under frontside layers 180. Frontside layers 180 may include one or more metallization levels (not depicted) interconnecting terminals of transistor structures 101-104 with other circuit nodes to form any suitable IC topology. Device layer 185 is over backside layers 190, which may comprise any suitable support substrate material 108 and/or device isolation material 140 and/or one or more other metallization levels (not depicted) that may further interconnect terminals of transistor structures 101-104 with other circuit nodes of an IC. Although four stacked transistor structures 101-104 are illustrated, any number of such stacked transistor structures may be arrayed over an area or footprint of an IC die.

Stacked transistor structures 101 and 103 are both low-voltage (LV) transistors, for example having an electrical breakdown voltage threshold below 3V. Stacked transistor structures 102 and 104 are both high-voltage (HV) transistors, which have an electrical breakdown voltage threshold significantly exceeding that of transistor structures 101 and 103. In some exemplary embodiments, HV stacked transistor structures 102, 104 have an electrical breakdown voltage threshold that is at least two times greater than that of LV transistor structures 101 and 103, and advantageously three times greater, or more.

Each stacked LV and HV transistor structure (e.g., 101 and 102) has a (nano)ribbon or wire (RoW) transistor architecture. LV transistor 101 includes a vertical (e.g., z-dimension) stack of an integer number *m* channel material layers 115 within vertical stack that further includes a stack of another integer number *n* channel material layers 116. HV transistor 103 likewise includes a vertical (e.g., z-dimension) stack of the integer number *p* channel material layers 115 within vertical stack that further includes a stack of another integer number *q* channel material layers 116. LV transistor channel material layers 115 are substantially coplanar with HV transistor channel material layers 115 (i.e., both share the same x-y plane). LV transistor channel material layers 116 are similarly substantially coplanar with HV transistor channel material layers 116. Although in FIG. 1, integer numbers *m, n, p* and *q* are all equal (e.g., three), the number of channel material layers 115 and 116 may differ within each of LV transistor stack 101 or HV transistor stack 102. The number of channel material layers 115 within HV transistor stack 102 may also differ from the number of channel material layers 115 within LV transistor stack 101. For example, *p* may be an integer number less than or equal to *m* and *q* may be an integer number less than or equal to *n.*

Each of channel material layers 115-116 have been patterned into a ribbon or wire that extends between impurity-doped semiconductor material 121 and 122. For CFET embodiments, impurity-doped semiconductor material 121 may be N-type and operable as a source and drain coupled to channel material layers 115. N-type source and drain semiconductor material 121 may have any chemical composition and microstructure suitable for an NMOS transistor. N-type source and drain semiconductor material 121 may include monocrystalline or polycrystalline semiconductor. In some embodiments, N-type source and drain semiconductor material 121 includes a Group IV or III-V semiconductor doped with any impurity dopants known to be suitable for N-type conductivity, and to any concentration known to be suitable for transistors.

Impurity-doped semiconductor material 122 may be P-type and operable as a source and drain coupled to channel material layers 116. P-type source and drain semiconductor material 122 may have any chemical composition and microstructure suitable for a PMOS transistor. Source and drain semiconductor material 122 may include monocrystalline or polycrystalline semiconductor. In some embodiments, source and drain semiconductor material 122 includes a Group IV or III-V semiconductor doped with any impurity dopants known to be suitable for P-type conductivity, and to any concentration known to be suitable for transistors. Space between N-type source and drain semiconductor material 121 and P-type source and drain semiconductor material 122 may be filled with any suitable insulator 154. Insulator 154 may be SiO₂ or a low-k dielectric material (e.g., SiOCH), for example.

In the illustrated example, LV transistor stack 101 is a CMOS stacked transistor, or "CFET" where NMOS and PMOS portions of CMOS transistor structure 101 are vertically stacked. Either NMOS or PMOS portions may be above or below the other. For clarity of discussion, channel material layers 115 are referred to as being within a lower portion 106 of LV transistor stack 101 while channel material layers 116 are within an upper portion 107 of LV transistor stack 101. HV transistor stack 102 is also a CMOS stacked transistor with channel material layers 115 being within lower portion 106 of HV transistor stack 102 while channel material layers 116 are within an upper portion 107 of HV transistor stack 102. Although CMOS transistor structures are illustrated, each of LV transistor stack 101 and HV transistor stack 102 may instead be of a single polarity (i.e., entirely NMOS or entirely PMOS).

For the illustrated CFET embodiment, LV transistor stack 101 includes a gate stack 111 between individual ones of channel material layers 115 and a gate stack 112 between individual ones of channel material layers 116. Gate stack 111 may include one or more gate dielectric materials and one or more gate electrode materials advantageous for lower (e.g., NMOS) portion 106. Gate stack 112 may include one or more gate dielectric materials and one or more gate electrode materials advantageous for upper (e.g., PMOS) portion 107. In some embodiments, gate stack 111 includes a high-k dielectric material and a first workfunction metal advantageous for N-type transistors while gate stack 112 includes a high-k dielectric and a second workfunction metal advantageous for P-type transistors.

Exemplary high-k dielectrics include metal oxides (e.g., comprising one or more of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate), or metal silicates (e.g., comprising one or more of above metals, oxygen and silicon). Examples of work function metals include ruthenium, palladium, platinum, cobalt, nickel, and conductive metal oxides (e.g., ruthenium oxide), hafnium, zirconium, titanium, tantalum, aluminum, alloys of these metals, and carbides of these metals such as hafnium carbide, zirconium carbide, titanium carbide, tantalum carbide, and aluminum carbide.

HV transistor stack 102 includes an intervening ribbon or wire of a semiconductor material layer 127 between individual ones of channel material layers 115. Similarly, there is an intervening ribbon or wire of semiconductor material layer 127 between channel material layers 116. Each semiconductor material layer 127 is of a different chemical composition than channel material layers 115, and of a different chemical composition than channel material layers 116. Each semiconductor material layer 127 may be of the same chemical composition. Alternatively, semiconductor material layers 127 within lower portion 106 may be of a different composition than semiconductor material layers 127 within upper portion 107.

In contrast to LV transistor stack 101, because semiconductor material layers 127 are in direct contact with channel material layers 115, there is no gate stack 111 between the ribbons or wires of channel material layers 115. Similarly, there is no gate stack 112 between the ribbons or wires of channel material layers 116 because semiconductor material layers 127 are in direct contact with channel material layers 116. Instead, the gate stack 111 and/or 112 of HV transistor 102 wraps around the plurality of channel material layers 115 and/or channel material layers 116 as a unit such that the gate stack(s) is(are) adjacent to a sidewall of channel material layers 115, 116 and adjacent to a sidewall of intervening semiconductor material layers 127. The thickness of gate dielectric material may be increased without inducing a concomitant reduction in the thickness of work function metal because gate stack 111 (and/or 112) is around, but not between channel material layers 115, 116. Semiconductor material layer 127 may also be operable as channel material along with channel material layers 115, 116 for an effectively wider transistor channel within one or more of the lower and upper portions 106, 107. Either, or both, of these structural attributes may enable HV transistor stack 102 to sustain a higher electrical breakdown threshold than LV transistor stack 101.

The chemical composition of channel material layers 115, 116 may vary with implementation. In accordance with some embodiments, channel material layers 115-116 are of a same Group IV, Group III-V, metal oxide, or metal chalcogenide semiconductor material. In some specific Group IV embodiments, channel material layers 115-116 all comprise primarily silicon and may be substantially (pure) silicon. For such embodiments, semiconductor material layer 127 may comprise germanium (e.g., Si₁₋ₓGe_{X}, Ge₁₋ₓSn_{X}, or substantially pure Ge).

In other embodiments, channel material layers 115 have a first composition while channel material layers 116 have a second composition. For example, channel material layers 115 may be of a first Group IV, Group III-V, metal oxide, or metal chalcogenide semiconductor material while channel material layers 116 may be of a second Group IV, Group III-V, metal oxide, or metal chalcogenide semiconductor material. In some specific Group IV embodiments, channel material layers 115 comprise primarily silicon and may be substantially (pure) silicon while channel material layers 116 comprise germanium (e.g., Si₁₋ₓGe_{X}, Ge₁₋ₓSn_{X}, or substantially pure Ge). For such embodiments, semiconductor material layer 127 within upper portion 107 may comprise germanium (e.g., Si₁₋ₓGe_{X}, Ge₁₋ₓSn_{X}, or substantially pure Ge) while semiconductor material layer 127 within lower portion 106 may comprise substantially (pure) silicon.

In other embodiments, channel material layers 115, 116 may comprise a transition metal and a chalcogen. The chalcogen may be sulfur, selenium, and tellurium (e.g., MSₓ, MSeₓ, or MTeₓ). The transition metal may be any transition metal such as any element of groups 4 through 11, the group 3 elements scandium and yttrium, and the inner transition metals (e.g., f-block lanthanide and actinide series). Transition metals advantageous for NMOS include molybdenum and tungsten while transition metals advantageously for PMOS include copper and indium. For such embodiments, semiconductor material layer 127 may comprise a transition metal chalcogenide having some alternative composition relative to that of channel material layers 115, 116, respectively. In still other embodiments, channel material layers 115, 116 may comprise one or more first metals and oxygen (i.e., first metal oxide semiconductor), such as, indium, gallium zinc oxide (e.g., InGaZnOₓ or simply "IGZO") while channel material layers 127 may comprise one or more second metals and oxygen (i.e., a second metal oxide semiconductor).

As further illustrated in FIG. 1, one or more spacer dielectrics 141 may be laterally adjacent to gate stacks 111, 112 of each of LV transistor 101 and HV transistor 102. Spacer dielectrics 141 may have any suitable composition, such as, but not limited to, SiN, SiO, SiON, or a low-k dielectric material (e.g., SiOCH).

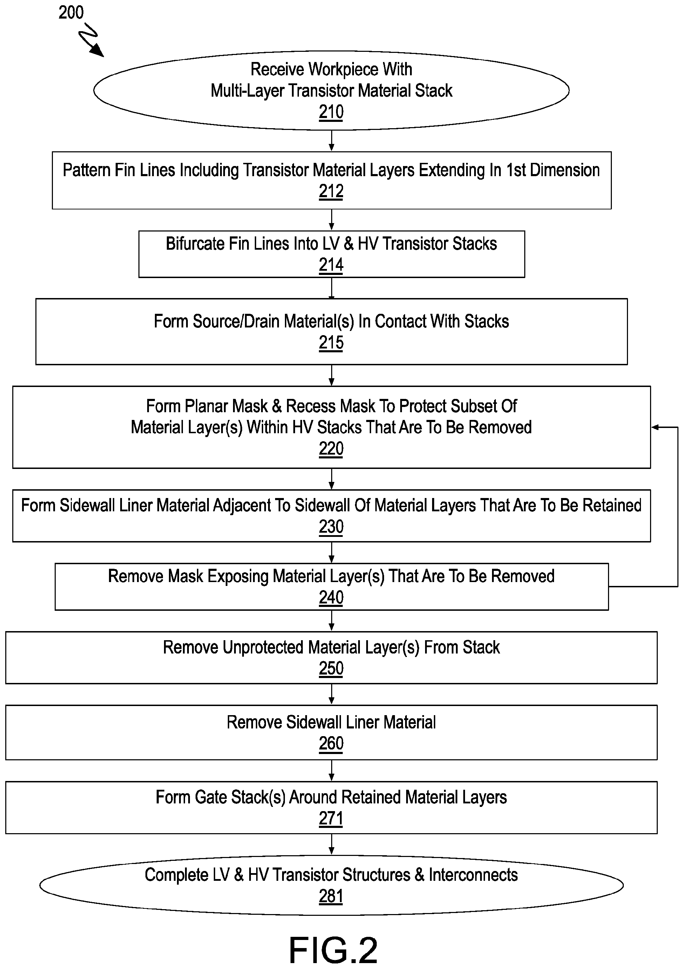

Stacked LV and HV transistors 101-104 may be fabricated according to a variety of methods. FIG. 2 is a flow diagram illustrating methods 200 for forming stacked LV and HV transistor structures, in accordance with some embodiments. Methods 200 begin at input 210 where a workpiece including a multi-layered transistor material stack is received. The transistor material stack includes channel material advantageous for at least one transistor polarity (e.g., N-type or P-type). For CFET embodiments, the transistor material stack includes channel material advantageous for a first transistor polarity (e.g., N-type) over channel material advantageous for a second transistor polarity (e.g., P-type).

The multi-layered transistor material stack is advantageously a bi-layer stack comprising a plurality of bi-layers. Each bi-layer may comprise a first semiconductor material layer in contact with a second semiconductor material layer. For a LV transistor, the first semiconductor material may be coupled to an N-type source and drain and/or a P-type source and drain while the second semiconductor material of the bilayer will be replaced with one or more gate stacks. For a HV transistor, both the first and second semiconductor materials may be coupled to an N-type and/or a P-type source and drain, with neither of first nor second semiconductor materials replaced by a gate stack. Therefore, one or more semiconductor materials that are to be removed as sacrificial from a LV transistor stack are to be retained in the HV transistor stack.

Methods 200 continue at block 212 where the transistor material stack is patterned into "fin" lines extending in a first dimension, for example according to any lithographic patterning process. This fin patterning defines ribbons or wires of the semiconductor material layers in the transistor material stack. For exemplary embodiments, fin lines may extend any length along a first dimension and have a width in a second, orthogonal dimension. Any lithographic masking process and material etch process(es) may be practiced at block 212. At block 214, the fin lines are bifurcated into fin segments with each fin segment comprising a transistor channel material stack. Fins may be bifurcated or cut with a second lithographic patterning process defining lines/trenches that are substantially orthogonal to the fin lines, for example.

At block 215, source and drain terminals are formed. For CFET embodiments, a first source and drain semiconductor material is formed in contact with channel material of a first transistor polarity and a second source and drain semiconductor material is formed in contact with channel material of a second transistor polarity. The source and drain semiconductor material(s) may be formed with epitaxial growth processes, for example seeding from sidewall surfaces of adjacent channel material layers. For CFET embodiments, an insulator, such as SiO, SiN, SiON, or SiOCH, may be deposited after a first epi source/drain growth and prior to a second epi source/drain growth performed.

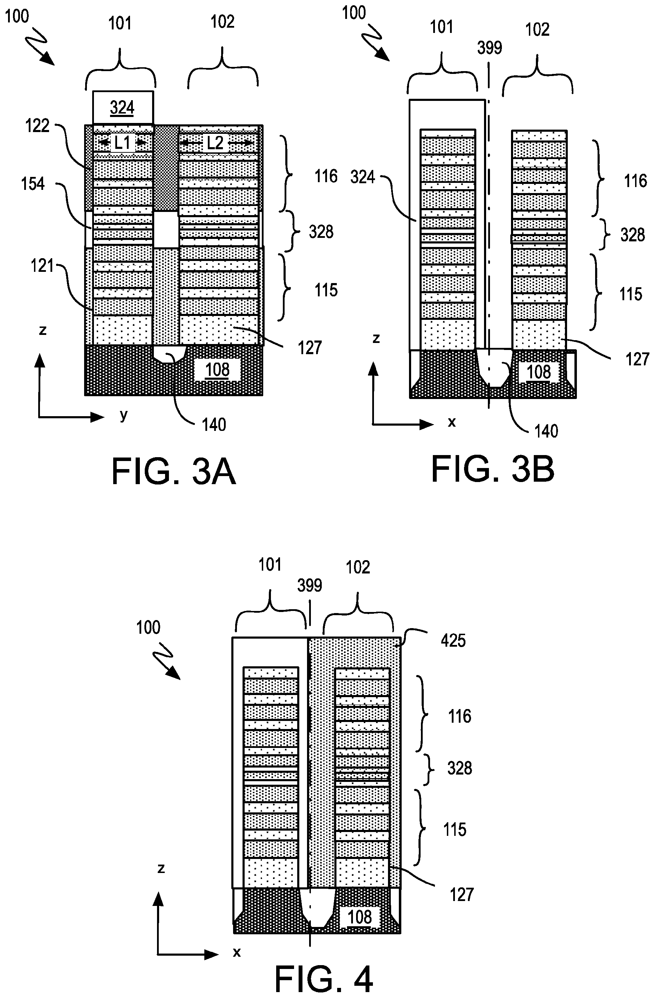

FIG. 3A and 3B illustrate cross-sectional views through orthogonal planes of both LV and HV transistor stacks, in accordance with some embodiments. FIG 3A and 3B illustrate examples of IC portion 100 (FIG. 1) immediately following the completion of block 215 in methods 200 (FIG. 2). Within the y-z plane illustrated by FIG. 3A, both LV transistor stack 101 and HV transistor stack 101 include channel material layers 115 and 116 with intervening semiconductor material layer 127 between them. A buffer 328 is between upper and lower portions of the transistor material stacks. Buffer 328 may comprise one or more material layers that may ultimately be retained within, or removed from, LV and HV transistor stacks 101 and 102. Buffer 328 may provide vertical (e.g., z-axis) separation between complementary MOS portions of each transistor stack. Buffer 328 may include a compositional and/or crystallographic transition region and/or a bonding region, for example where two epitaxially grown bi-layer material stacks may have been joined together within any suitable bonding process. In the illustrated embodiment, buffer 328 comprises a bi-layer superlattice including layers of the same composition and crystal orientation as channel material layers 115 and/or 116 and intervening semiconductor material layer 127.

Within LV transistor 101, channel material layers 115, 116 span a channel length L1 between source and drain semiconductor materials 121, 122. Although L1 may vary with implementation, is some exemplary embodiments channel length L1 is in the range of 10-20nm. Within HV transistor 102, channel material layers 115, 116 span a channel length L2 that is advantageously significantly longer than channel length L1. HV channel length L2 may also vary with implementation. In some exemplary embodiments where channel length L1 is in the range of 10-20nm, channel length L2 is in the range of 75-250nm.

Within x-z plane illustrated by FIG. 3B, a width of channel material layers 115 and 116 and intervening semiconductor material layer 127 is illustrated for LV transistor 101 and HV transistor 102. Although transistor structures 101 and 102 don't share an x-z plane in FIG. 1, for clarity their sections are aligned on either side of a cut line 399. In the example illustrated in FIG. 3A and FIG. 3B, a channel mask 324 is retained over the LV transistor 101 while the channel mask material has been removed from HV transistor 102 in preparation for HV-specific processing.

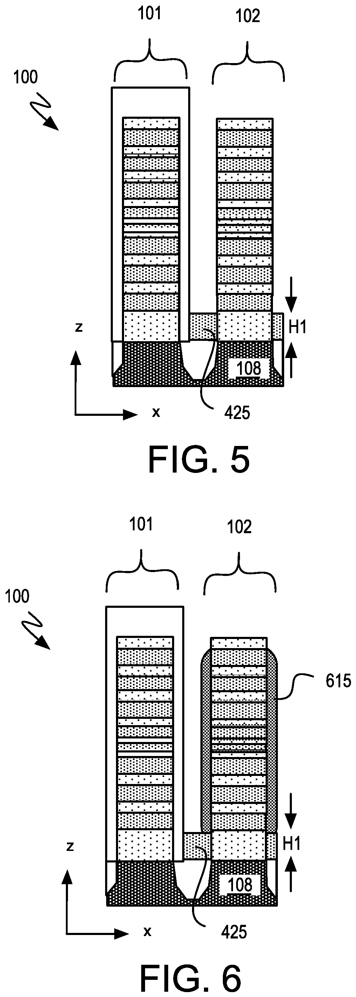

Returning to FIG. 2, methods 200 continue at block 220 where a planar mask is formed over at least the HV transistor structure. The mask may be of any material that can be recess etched selectively around the HV transistor structure to protect a subset of the material layers within the HV transistor material stack that is ultimately be removed as sacrificial. FIG. 4 illustrates IC structure portion 100 evolving from FIG. 3B to further include mask material 425. Mask material 425 may be any suitable material, such as diamond-like carbon (DLC) or another CVD carbon material, for example. As shown, a top surface of the mask material is substantially planarized. FIG. 5 further illustrates a recess etch of mask material 425, which exposes an upper portion of HV transistor 102 above a mask height H1.

Returning to FIG. 2 with a lower portion of the HV transistor stack protected by mask material, methods 200 continue at block 230 where a sidewall liner material may be deposited upon a sidewall of channel material layers within the upper portion of the HV transistor stack. The liner material may be any suitable material (e.g., dielectric or metallic), and deposited with any sufficiently conformal deposition technique (e.g., ALD). The liner material is advantageously of a composition that can be readily removed selectively to the underlying transistor material stack. The liner material may then be anisotropically etched to form a sidewall spacer that exposes the underlying mask material. While the upper portion of the HV transistor stack is protected by the liner material, at block 240 the underlying mask material is removed from the lower portion of the HV transistor stack.

FIG. 6 illustrates the formation of a sidewall liner 615 following a conformal deposition process and anisotropic spacer etchback. Although the composition of sidewall liner 615 may vary with implementation, in some embodiments sidewall liner 615 comprises Ti (e.g., TiN). Mask material 425 may either be removed to expose a sidewall of HV transistor stack 102, or it may be augmented with additional mask material.

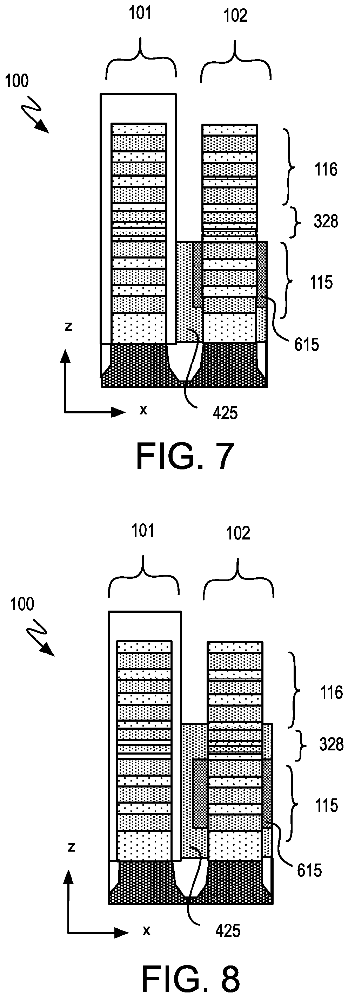

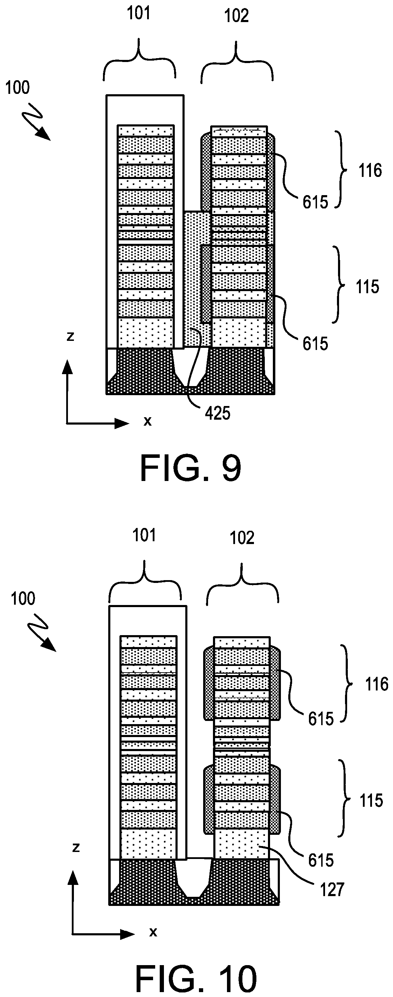

Returning to FIG. 2 methods 200 continue with any number of iterations through blocks 220, 230 and 240 to build up sidewall liner material adjacent to any portion(s) of the HV transistor stack that are to be retained within an HV transistor structure. FIG. 7 further illustrates an example where additional mask material 425 has been deposited and recessed down to expose buffer 328. As shown, a portion of sidewall liner 615 not protected by mask material 425 has also been stripped away, for example with a selective wet etch. In FIG. 8, additional mask material 425 has been deposited and etched back to cover sidewalls of buffer 328. FIG. 9 illustrates another conformal deposition of liner material and anisotropic spacer etchback, forming additional sidewall liner 615 adjacent to any desired number of channel material layers 116. As further illustrated in FIG. 10, mask material 425 has been selectively removed from around HV transistor 102 leaving only channel material layers 115 and 116 (and intervening semiconductor material layer 127) protected by sidewall liner 615.

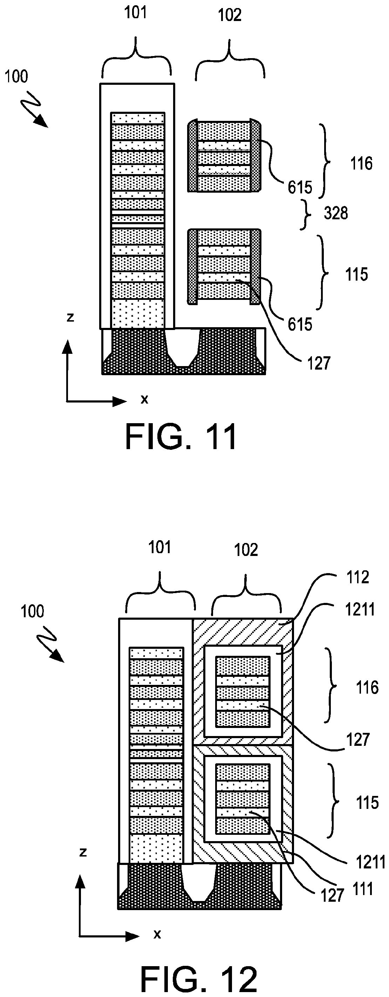

Returning to FIG. 2, methods 200 continue at block 250 where unprotected material layer(s) are removed from at least the HV transistor stack. One or more isotropic etch processes selective to one or more of the channel material(s) and intervening material(s) may be practiced at block 250. The etches performed at block 250 may be practiced while LV transistor stacks remain protected by channel mask material, for example. Following transistor stack etching, the sidewall liner material is selectively removed at block 260. FIG. 11 illustrates an example where channel material layers 115 and/or 116, as well as intervening semiconductor material layer 127 has been removed except where protected by sidewall liner 615. As shown, semiconductor material layer 127 at the top and/or bottom surfaces of channel material layers 115 and 116 has been removed through selective etching processes.

Returning to FIG. 2, methods 200 continue at block 271 where one or more gate stacks are formed around the material layers of the transistor stack that have been retained. For the HV transistor stacks, these material layers include the channel material layers also included in LV transistor stacks as well as the intervening semiconductor material. Depending on the composition of the intervening semiconductor material, bandgap and channel mobilities of the intervening semiconductor material may be more or less matched to those of the channel semiconductor material so that sub-threshold behavior, drive current, and transconductance, etc. of a HV transistor is a function of the multiple semiconductor material compositions.

In exemplary embodiments, block 271 entails the formation of a thick gate insulator suitable for sustaining higher voltages (e.g., V_{dd}) than LV transistors. The thick gate insulator may be any known to be suitable for the application and have any thickness suitable for specified electric fields that will be experienced during HV FET operation. One or more gate terminal/electrode materials may then be formed over the gate insulator. FIG. 12 illustrates some exemplary CFET embodiments where both a HV PMOS and a HV NMOS transistor is fabricated within HV transistor structure 102. In this example, a first gate stack 111 including at least a thick gate dielectric 1211 and a first workfunction metal has been formed around channel material layers 115 and the intervening semiconductor material layer 127 within the lower portion of HV transistor stack 102. A second gate stack 112 including at least thick gate dielectric 1211 and another workfunction metal has been formed around channel material layers 116 and the intervening semiconductor material layer 127 within the lower portion of HV transistor stack 102. Gate stacks 111, 112 are therefore adjacent to a sidewall of all semiconductor material layers 115, 116 and 127. The chemical composition of thick gate dielectric 1211 may be the same between lower and upper portions of HV transistor stack 102.

Returning to FIG. 2, methods 200 end at the output 281 where LV and HV transistor structures are completed. The LV transistor structures may be processed, for example, following any known CFET techniques. For example, a LV CFET process flow may be practiced beginning with the removal of a channel mask. Alternatively, a LV NMOS or PMOS specific process flow may be practiced. An IC die may then be completed by fabricating any number of frontside and backside metallization levels according to any known techniques.

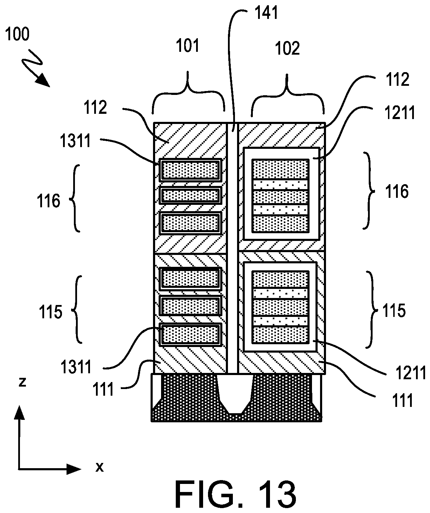

FIG. 13 illustrates IC portion 100 including LV and HV transistor structures that ready for interconnect metallization. In this example, gate stacks 111 and 112 have been formed around channel material layers 115, 116 of LV transistor 101. Intervening semiconductor material layer 127 has been completely removed and replaced with gate stacks 111 and 112. For LV transistor implementations, gate stacks 111 and 112 include a thin gate insulator 1311. The thin gate insulator may have any composition known to be suitable for the application and have any thickness. In some examples, gate insulator 1211 is at least 1.5-2 times thicker than gate insulator 1311. Gate insulator 1311 may have substantially the same composition as gate insulator 1211, or may be of a different chemical composition. In some exemplary embodiments, workfunction metals included in gate stacks 111 and 112 are substantially the same between LV and HV transistors. However, workfunction metals may also be varied between HV and LV transistors.

Notably, the exemplary techniques of depositing, planarizing and recess etching a mask material in combination with forming a substantially conformal transistor stack sidewall liner may be practiced in different sequences to independently process top and bottom portions of multi-layered transistor material stacks. While methods 200 illustrate an exemplary approach to fabricating both LV and HV CFET transistors, the blocks of methods 200 may be alternatively sequenced or otherwise modified to fabricate LV and HV transistors of only one polarity (e.g., PMOS or NMOS).

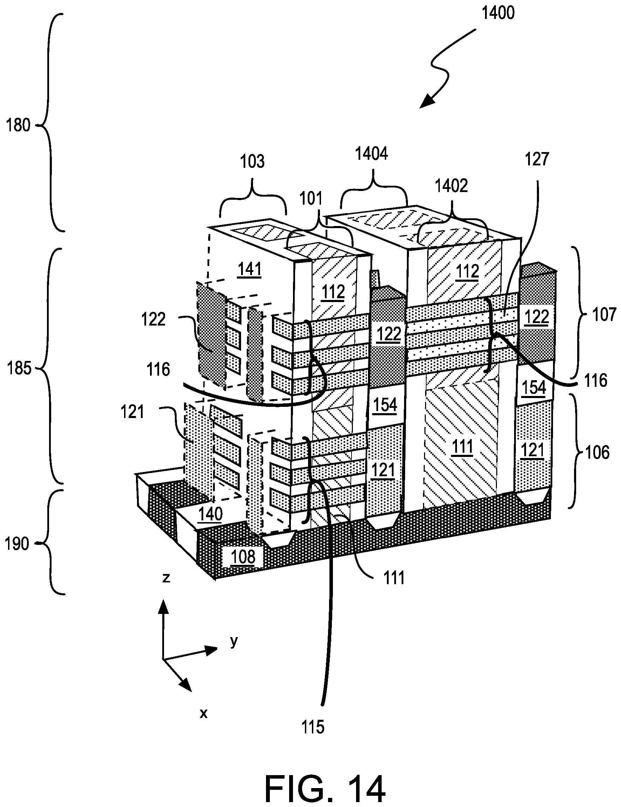

The techniques illustrated in methods 200 may also be leveraged to fabricate passive resistor structures. FIG. 14 is an isometric illustration of an IC portion 1400 including LV stacked transistors 101, 103 and stacked resistors 1402, 1404, in accordance with some embodiments. In FIG. 14, reference numbers from FIG. 1 are retained for features that may be substantially as previously described for IC portion 100 (FIG. 1). Features in IC portion 1400 that are shared with IC portion 100 may have any of the properties described in the context of IC portion 100.

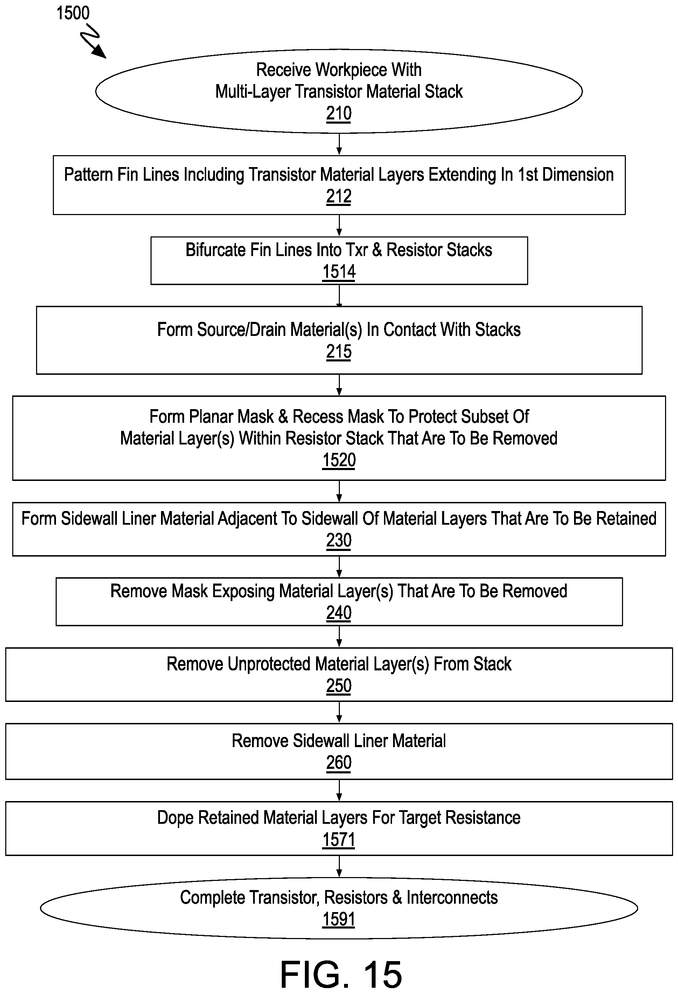

As shown in FIG. 15, stacked resistor 1402 comprises channel material layers 116, which are substantially the same as channel material layers 116 within LV transistor 101 and may have any of the attributes and/or properties described elsewhere herein. Similar to a HV transistor, stacked resistor 1402 further includes semiconductor material layer 127 intervening between channel material layers 116. Hence, as described elsewhere in the context of a HV transistor, semiconductor material layer 127 is not replaced with a gate stack and is instead retained as a permanent feature of stacked resistor 1402.

In contrast to HV transistor structures described elsewhere herein, one or more channel material layer 116 and one or more semiconductor material layer 127 comprises a significant concentration of electrically active impurities (i.e., dopants). Although the impurity may vary with implementation, for some exemplary embodiments where channel material layers 116 are a Group IV material (e.g., substantially pure silicon), the impurity may be one or more of B, Ga, P, As or Sb. These impurities may be at any concentration (atoms/cm³) known to be suitable for achieving a predetermined sheet resistance for a given chemical composition of channel material layers 116 and/or semiconductor material layer 127. For example, within stacked resistor 1402, dopant concentration within channel material layers 116 may be anywhere from 2-8 orders of magnitude greater than a concentration of the same impurity within channel material layers 116 of LV transistor 101. In some embodiments, dopant concentration of channel material layers 116 within stacked resistor 1402 are at least 7e15/cm³. Like the HV transistor structures described elsewhere herein, a resistor structure may include any number of channel material layers 116 and include any number of intervening layers of semiconductor material layer 127. Impurity doping may be advantageously substantially uniform within these layers, or may have some variation, for example as a function of the impurity doping technique(s) employed.

In the example illustrated in FIG. 14, stacked resistor structure 1402 is surrounded by one or more gate stacks 111, 112, for example substantially as described above in the context of LV and HV transistor structures. However, in the context of resistor structure 1402 these gate stacks may be considered dummy gate stacks retained as features of the integration of resistor structure 1402 with adjacent LV/HV transistor structures. Accordingly, gate stacks 111, 112 are illustrated with dashed line in FIG. 14 and may instead be a variety of other suitable materials, such as a low-k or conventional dielectric material.

FIG. 15 is a flow diagram illustrating methods 1500 for forming a LV stacked transistor structure and a stacked resistor structure, in accordance with some embodiments. Methods 1500 may be practiced to fabricate LV stacked transistor 101 and resistor 1402, for example. Methods 1500 may be practiced in combination with methods 200 (FIG. 2) to further integrate HV transistor structures and stacked resistor structures, with or without LV transistors structures.

Methods 1500 again begin with input 210 where a workpiece including a multi-layered transistor material stack is received. The stack may be substantially the same as that received as an input to methods 200. The transistor material stack may, for example, include channel material advantageous for at least one transistor polarity (e.g., N-type or P-type). For CFET embodiments, the transistor material stack may include channel material advantageous for a first transistor polarity (e.g., N-type) and channel material advantageous for a second transistor polarity (e.g., P-type). The multi-layered transistor material stack may be a bi-layer stack comprising a plurality of bi-layers, for example.

Methods 1500 continue at block 212 where the transistor material stack is patterned, for example into fin lines substantially as described above, rendering each material layer within the stack a ribbon or wire extending in a first dimension. At block 1514, the fin lines are bifurcated into transistor (LV and/or HV) stacks and into stacks that are to be fabricated into passive resistor structures. Methods 1500 continue at block 215, for example substantially as described above, where impurity-doped semiconductor material is formed as terminals at opposite ends of the multi-layered material stacks. For transistor stacks, source and drain terminals comprising the impurity-doped semiconductor material are fabricated at block 215. For resistor stacks, the same impurity-doped semiconductor material is fabricated as resistor terminals.

Methods 1500 (FIG. 15) continue at block 1520 wherein a planar mask material is deposited over a resistor stack. Block 1520 is similar to block 220 of methods 200 (FIG. 2). The mask may again be of any material that can be recessed selectively around the resistor material stack to protect a subset of the material layers within the stack that are ultimately be removed as sacrificial. At block 230, sidewall liner material is formed adjacent to a sidewall of material layers that are to be retained within a resistor structure. The sidewall liner material and techniques for forming the liner material may be any of those described elsewhere herein for block 230. At block 240. mask material is removed selectively to the sidewall liner material, exposing material layers of the resistor structure that are to be removed at block 250. The sidewall liner material is then removed at block 260.

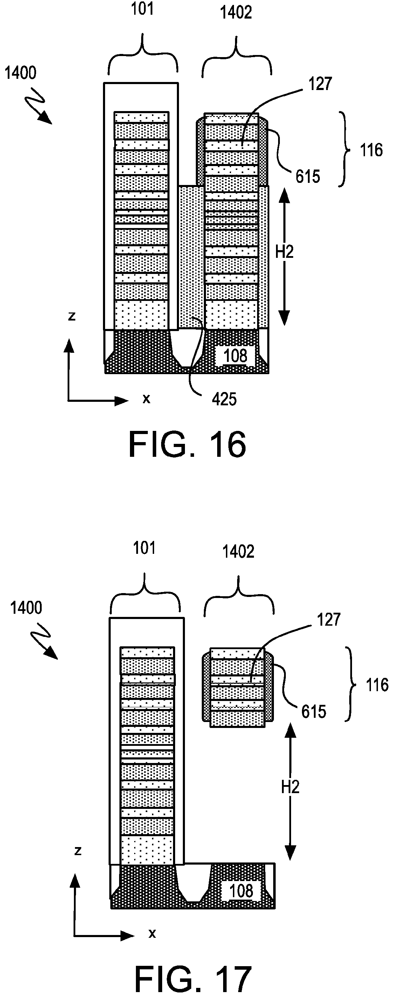

FIG. 16 illustrates IC structure portion 1400 that further includes mask material 425. Mask material 425 may be any suitable material, such as diamond-like carbon (DLC) or another CVD carbon material, for example. As shown, mask material 425 has been recessed with an etchback process to expose an upper portion of resistor 1402 above a mask height H2. Mask height H2 may be modulated to fabricate a resistor of any desired cross-sectional dimension limited only by the transistor material stack height. Sidewall liner material 615 has been formed adjacent to sidewalls of channel material 116 and adjacent to sidewalls of intervening semiconductor material layer 127. Sidewall liner (material) 615 may have any suitable composition, for example as described elsewhere herein. FIG. 17 further illustrates removal of mask material 425 and removal of material layers of resistor 1402 that are exposed by removal of the mask material.

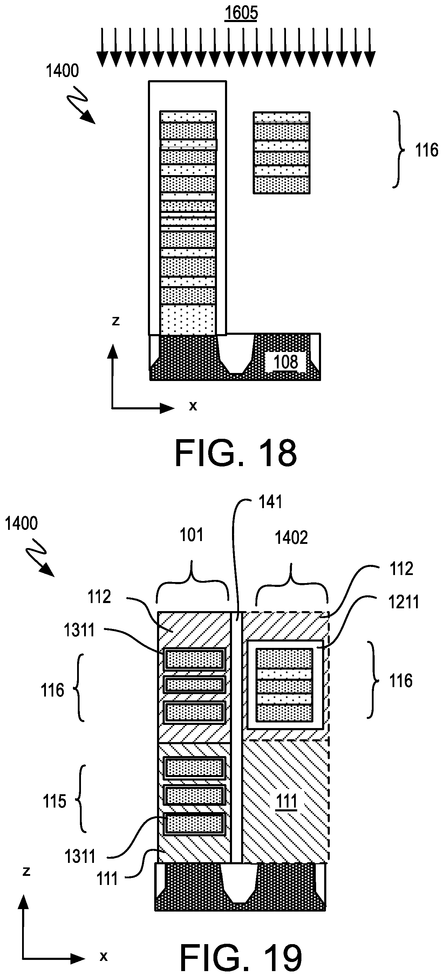

Returning to FIG. 15, methods 1500 continue at block 1571 where material layers retained within the resistor stack are impurity doped. In exemplary embodiments, implant doping is practiced at block 1571. In other embodiments, impurity doped films may be deposited at block 1571. One or more thermal diffusion and/or dopant activation may also be practiced at block 1571, for example to electrically activate some portion of the impurities introduced. FIG. 18 illustrates an example where sidewall liner material 615 has been removed and impurities are introduced with an energetic implant 1605. Implant 1605 may introduce one or more P-type and/or N-type impurities at any dose and energy level, to reach a target resistivity within channel material layers 116 and semiconductor material layer 127.

Returning to FIG. 15, methods 1500 end at output 1591 where LV transistor structures and resistor structures are completed. The LV transistor structures may be processed, for example, following any known techniques. For example, a LV CFET process flow may be practiced beginning with the removal of a channel mask. Alternatively, a LV NMOS or PMOS specific process flow may be practiced. An IC die may then be completed by fabricating any number of frontside and backside metallization levels to interconnect various transistors and resistors into a functional integrated circuit.

FIG. 19 illustrates IC portion 1400 now including LV transistor structure 101 and resistor structure 1402. IC portion 1400 may be completed with the addition of interconnect metallization, for example coupling terminals of the LV transistor structure 101 and resistor structure 1402 into circuitry. In the illustrated example, gate stacks 111 and 112 have been formed around channel material layers 115, 116 of LV transistor stack 101. Intervening semiconductor material layer 127 has been completely removed and replaced with gate stacks 111 and 112. For LV transistor implementations, gate stacks 111 and 112 include a thin gate insulator 1311. A HV transistor may also be implemented, for example according to embodiments described elsewhere herein. Although illustrated as including gate stacks 111 and 112, resistor structure 1402 may instead lack dummy gate stacks.

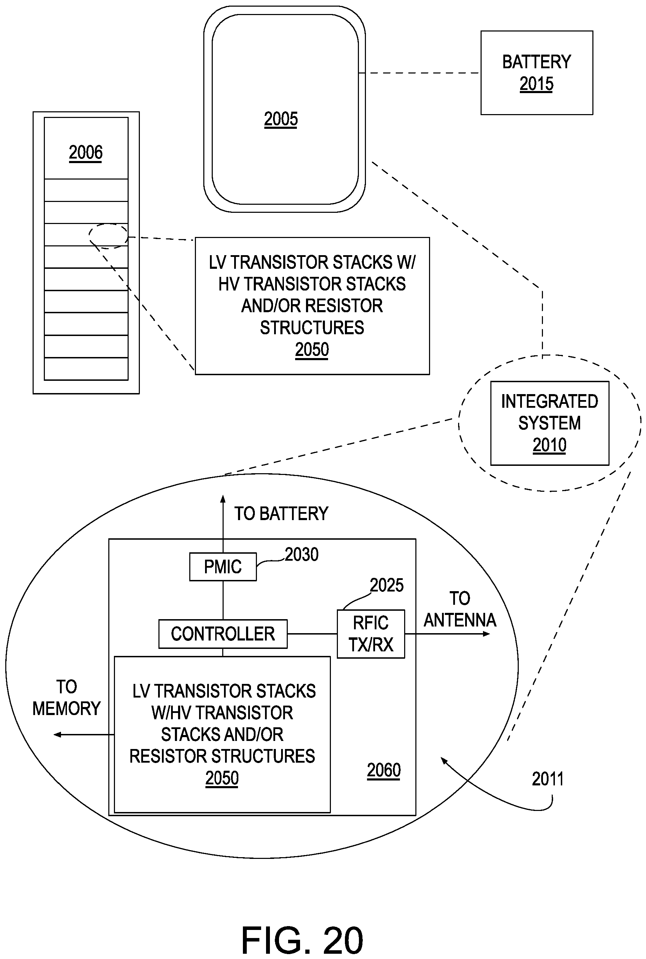

The HV transistor and resistor structures described above may be employed in a wide range of IC devices and further integrated in a wide range of computer-based applications. FIG. 20 illustrates a mobile computing platform 2005 and a server machine 2006 employing a packaged IC die 2050 including a stacked LV transistor structures with at least one of HV transistor structures or resistor structures, for example as described elsewhere herein. Server machine 2006 may be any commercial server, for example including any number of high-performance computing platforms disposed within a rack and networked together for electronic data processing, which in the exemplary embodiment includes a packaged IC die 2050 comprising stacked LV transistors, stacked HV transistors and/or stacked resistors, for example as described elsewhere herein.

The mobile computing platform 2005 may be any portable device configured for each of electronic data display, electronic data processing, wireless electronic data transmission, or the like. For example, the mobile computing platform 2005 may be any of a tablet, a smart phone, laptop computer, etc., and may include a display screen (e.g., a capacitive, inductive, resistive, or optical touchscreen), an integrated system 2010, and a battery 2015.

As illustrated in the expanded view, one or more of a power management integrated circuit (PMIC) 2030 or RF (wireless) integrated circuit (RFIC) 2025 including a wideband RF (wireless) transmitter and/or receiver may be further coupled to a system substrate 2060. A PMIC may perform battery power regulation, DC-to-DC conversion, etc., and so has an input coupled to battery 2015 and an output providing a current supply to other functional modules. An RFIC may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G and beyond.

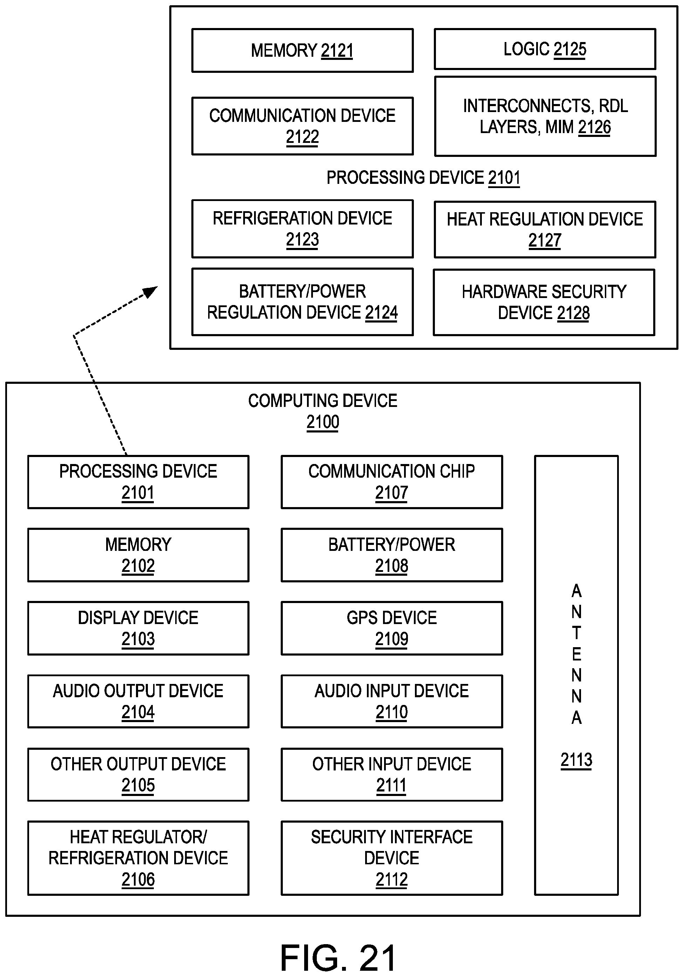

FIG. 21 is a block diagram of a cryogenically cooled computing device 2100 in accordance with some embodiments. For example, one or more components of computing device 2100 may include any of the stacked LV and HV transistor structures and/or resistor structures discussed elsewhere herein.

A number of components are illustrated in FIG. 21 as included in computing device 2100, but any one or more of these components may be omitted or duplicated, as suitable for the application. In some embodiments, some or all of the components included in computing device 2100 may be attached to one or more printed circuit boards (e.g., a motherboard). In some embodiments, various ones of these components may be fabricated onto a single system-on-a-chip (SoC) die. Additionally, in various embodiments, computing device 2100 may not include one or more of the components illustrated in FIG. 20, but computing device 2100 may include interface circuitry for coupling to the one or more components. For example, computing device 2100 may not include a display device 2103, but may include display device interface circuitry (e.g., a connector and driver circuitry) to which display device 2103 may be coupled.

Computing device 2100 may include a processing device 2101 (e.g., one or more processing devices). As used herein, the term processing device or processor indicates a device that processes electronic data from registers and/or memory to transform that electronic data into other electronic data that may be stored in registers and/or memory. Processing device 2101 may include a memory 2121, a communication device 2122, a refrigeration/active cooling device 2123, a battery/power regulation device 2124, logic 2125, interconnects 2126 (i.e., optionally including redistribution layers (RDL) or metal-insulator-metal (MIM) devices), a heat regulation device 2127, and a hardware security device 2128.

Processing device 2101 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 2101 may include a memory 2102, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 2121 includes memory that shares a die with processing device 2101. This memory may be used as cache memory and may include embedded dynamic random-access memory (eDRAM) or spin transfer torque magnetic random-access memory (STT-M RAM).

Computing device 2100 may include a heat regulation/refrigeration device 2106. Heat regulation/refrigeration device 2106 may maintain processing device 2101 (and/or other components of computing device 2100) at a predetermined low temperature during operation. This predetermined low temperature may be any temperature discussed elsewhere herein.

In some embodiments, computing device 2100 may include a communication chip 2107 (e.g., one or more communication chips). For example, the communication chip 2107 may be configured for managing wireless communications for the transfer of data to and from computing device 2100. The term "wireless" and its derivatives may be used to describe circuits, devices, systems, methods, techniques, communications channels, etc., that may communicate data through the use of modulated electromagnetic radiation through a nonsolid medium.

Communication chip 2107 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 2107 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 2107 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2107 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2107 may operate in accordance with other wireless protocols in other embodiments. Computing device 2100 may include an antenna 2113 to facilitate wireless communications and/or to receive other wireless communications (such as AM or FM radio transmissions).

In some embodiments, communication chip 2107 may manage wired communications, such as electrical, optical, or any other suitable communication protocols (e.g., the Ethernet). As noted above, communication chip 2107 may include multiple communication chips. For instance, a first communication chip 2107 may be dedicated to shorter-range wireless communications such as Wi-Fi or Bluetooth, and a second communication chip 2107 may be dedicated to longer-range wireless communications such as GPS, EDGE, GPRS, CDMA, WiMAX, LTE, EV-DO, or others. In some embodiments, a first communication chip 2107 may be dedicated to wireless communications, and a second communication chip 2107 may be dedicated to wired communications.

Computing device 2100 may include battery/power circuitry 2108. Battery/power circuitry 2108 may include one or more energy storage devices (e.g., batteries or capacitors) and/or circuitry for coupling components of computing device 2100 to an energy source separate from computing device 2100 (e.g., AC line power).

Computing device 2100 may include a display device 2103 (or corresponding interface circuitry, as discussed above). Display device 2103 may include any visual indicators, such as a heads-up display, a computer monitor, a projector, a touchscreen display, a liquid crystal display (LCD), a light-emitting diode display, or a flat panel display, for example.

Computing device 2100 may include an audio output device 2104 (or corresponding interface circuitry, as discussed above). Audio output device 2104 may include any device that generates an audible indicator, such as speakers, headsets, or earbuds, for example.

Computing device 2100 may include an audio input device 2110 (or corresponding interface circuitry, as discussed above). Audio input device 2110 may include any device that generates a signal representative of a sound, such as microphones, microphone arrays, or digital instruments (e.g., instruments having a musical instrument digital interface (MIDI) output).

Computing device 2100 may include a global positioning system (GPS) device 2109 (or corresponding interface circuitry, as discussed above). GPS device 2109 may be in communication with a satellite-based system and may receive a location of computing device 2100, as known in the art.

Computing device 2100 may include another output device 2105 (or corresponding interface circuitry, as discussed above). Examples include an audio codec, a video codec, a printer, a wired or wireless transmitter for providing information to other devices, or an additional storage device.

Computing device 2100 may include another input device 2111 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2100 may include a security interface device 2112. Security interface device 2112 may include any device that provides security measures for computing device 2100 such as intrusion detection, biometric validation, security encode or decode, managing access lists, malware detection, or spyware detection. In some examples, security interface device 2112 comprises OTP ROM further including a via MIM fuse, for example as described elsewhere herein.

Computing device 2100, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments so described, but instead can be practiced with modification and alteration without departing from the scope of the appended claims. For example, the above embodiments may include specific combinations of features as further provided below.

In first examples, an apparatus comprises a first stack of ribbons or wires (RoWs) of a first semiconductor material, the first stack of RoWs coupled to impurity-doped semiconductor terminals and the RoWs separated from each other by at least a gate dielectric material. The apparatus comprises a second stack of RoWs of the first semiconductor material, the second stack of RoWs coupled to impurity-doped semiconductor terminals, wherein the second stack further comprises an intervening RoW of a second semiconductor material between individual RoWs of the first semiconductor material.

In second examples, for any of the first examples the impurity-doped semiconductor terminals comprise a source and a drain semiconductor material,. The apparatus further comprises a first gate stack over the first stack, the first gate stack comprising the gate dielectric material and a gate electrode material adjacent to a sidewall of, and between, the RoWs of the first semiconductor material. The apparatus comprises a second gate stack over the second stack, the second gate stack comprising a gate dielectric and a gate electrode material adjacent to a sidewall of the RoWs of the first semiconductor material and adjacent to a sidewall of the RoW of the second semiconductor material.

In third examples, for any of the second examples the RoW of the second semiconductor material between a two of the RoWs of the first semiconductor material within the second stack is substantially co-planar with the first gate stack between two of the RoWs of the first semiconductor material within the first stack.

In fourth examples, for any of the second through third examples the first gate stack comprises a gate dielectric of a first thickness and the second gate stack comprises a gate dielectric of a second thickness, greater than the first thickness.

In fifth examples, for any of the second through fourth examples the first stack comprises first RoWs of the first semiconductor material coupled to a first source and a first drain comprising p-type impurities, and second RoWs of the first semiconductor material coupled to a second source and a second drain comprising n-type impurities. The second stack comprises first RoWs of the first semiconductor material coupled to a first source and a first drain comprising p-type impurities, second RoWs of the first semiconductor material coupled to a second source and a second drain comprising n-type impurities, a first RoW of the second semiconductor material between individual ones of the first RoWs of the first semiconductor material, and a second RoW of the second semiconductor material between individual ones of the second RoWs of the first semiconductor material.

In sixth examples, for any of the first through fifth examples the first semiconductor material is a first of silicon or germanium, or a first SiGe alloy, and the second semiconductor material is a second of silicon or germanium, or a second SiGe alloy.

In seventh examples, for any of the sixth examples the first semiconductor material is silicon and the second semiconductor material is a SiGe alloy.

In eighth examples, for any of the first through the seventh examples the RoW of the second semiconductor material is between, and in direct contact with, two of the RoWs of the first semiconductor material.

In ninth examples, for any of the first through eighth examples individual ones of the RoWs of the first semiconductor material within the first stack are substantially co-planar with corresponding ones of the RoWs of the first semiconductor material within the second stack.

In tenth examples, for any of the first through ninth examples the first stack comprises a first integer number of RoWs of the first semiconductor material, the second stack comprises a second integer number of RoWs of the first semiconductor material, and the second integer number is less than, or equal to, the first integer number.

In eleventh examples, for any of the first through tenth examples the RoWs of the first semiconductor material in the second stack comprise a first impurity dopant concentration that is at least two orders of magnitude greater than a second impurity dopant concentration in the RoWs of the first semiconductor material in the first stack.

In twelfth examples, an apparatus comprises a first stacked transistor structure comprising a first stack of channel material layers coupled to a source and a drain, and a first gate stack comprising a gate insulator and a gate electrode material adjacent to a sidewall of, and between, individual ones of the channel material layers. The apparatus comprises a second stacked transistor structure comprising a second stack of the channel material layers coupled to a source and drain, the second stack further comprises an intervening material layer between individual ones of the channel material layers, and a second gate stack comprising a gate insulator and a gate electrode material adjacent to a sidewall of the channel material layers and adjacent to a sidewall of the intervening material layer. The apparatus comprises interconnect metallization levels over the first and second stacked transistor structures, the interconnect metallization levels interconnecting the first and second stacked transistor structures with other stacked transistor structures.

In thirteenth examples, for any of the twelfth examples the channel material layers comprise a first group IV semiconductor material, the intervening material layer comprises a second group IV semiconductor material, the first gate stack comprises a gate insulator of a first thickness, and the second gate stack comprises a gate insulator of a second thickness that is at least twice the first thickness.

In fourteenth examples, for any of the thirteenth examples the first Group IV semiconductor material is substantially pure Si and the second group IV semiconductor material an alloy of Si and Ge.

In fifteenth examples, for any of the thirteenth through fourteenth examples the first stacked transistor structure is associated with a first electrical breakdown threshold, the second stack transistor structure is associated with a second electrical breakdown threshold, and the second electrical breakdown threshold is at least two times greater than the first electrical breakdown threshold.

In sixteenth examples, an apparatus comprises a transistor structure comprising a first stack of first semiconductor material layers coupled to a pair of terminals comprising an impurity-doped semiconductor material and a gate stack comprising a gate insulator and a third terminal comprising a metal. The gate stack is adjacent to a sidewall of, and between, individual ones of the first semiconductor material layers. The apparatus comprises a resistor structure comprising a second stack of the first semiconductor material layers coupled between a pair of terminals comprising the impurity-doped semiconductor material. The first semiconductor material layers within the second stack have an impurity concentration that is at least two orders of magnitude higher than that of the first semiconductor material layers within the first stack. A second semiconductor material layer is between individual ones of the first semiconductor material layers within the second stack.

In seventeenth examples, for any of the sixteenth examples the first semiconductor material layers comprise a first group IV semiconductor material, and the second semiconductor material layer comprises a second group IV semiconductor material.

In eighteenth examples, for any of the seventeenth examples the first Group IV semiconductor material is substantially pure Si and the second group IV semiconductor material an alloy of Si and Ge.

In nineteenth examples, for any of the sixteenth through eighteenth examples the first stack of first semiconductor material layers comprises at least four of the first semiconductor material layers. The second stack of first semiconductor material layers comprises at least one the first semiconductor material layers.

In twentieth examples, for any of the nineteenth examples one of the first semiconductor material layers within the second stack is substantially co-planar with an uppermost one of the first semiconductor material layers within the first stack.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An apparatus, comprising:
a first stack of ribbons or wires (RoWs) of a first semiconductor material, the first stack of RoWs coupled to impurity-doped semiconductor terminals and the RoWs separated from each other by at least a gate dielectric material; and
a second stack of RoWs of the first semiconductor material, the second stack of RoWs coupled to impurity-doped semiconductor terminals, wherein the second stack further comprises an intervening RoW of a second semiconductor material between individual RoWs of the first semiconductor material.

2. The apparatus of claim 1, wherein the impurity-doped semiconductor terminals comprise a source and a drain semiconductor material, and wherein the apparatus further comprises:
a first gate stack over the first stack, the first gate stack comprising the gate dielectric material and a gate electrode material adjacent to a sidewall of, and between, the RoWs of the first semiconductor material; and
a second gate stack over the second stack, the second gate stack comprising a gate dielectric and a gate electrode material adjacent to a sidewall of the RoWs of the first semiconductor material and adjacent to a sidewall of the RoW of the second semiconductor material.

3. The apparatus of claim 2, wherein the RoW of the second semiconductor material between a two of the RoWs of the first semiconductor material within the second stack is substantially co-planar with the first gate stack between two of the RoWs of the first semiconductor material within the first stack.

4. The apparatus of any one of claims 2-3, wherein the first gate stack comprises a gate dielectric of a first thickness and the second gate stack comprises a gate dielectric of a second thickness, greater than the first thickness.

5. The apparatus of any one of claims 2-4, wherein:
the first stack comprises:
first RoWs of the first semiconductor material coupled to a first source and a first drain comprising p-type impurities; and
second RoWs of the first semiconductor material coupled to a second source and a second drain comprising n-type impurities; and
the second stack comprises:
first RoWs of the first semiconductor material coupled to a first source and a first drain comprising p-type impurities;
second RoWs of the first semiconductor material coupled to a second source and a second drain comprising n-type impurities;
a first RoW of the second semiconductor material between individual ones of the first RoWs of the first semiconductor material; and
a second RoW of the second semiconductor material between individual ones of the second RoWs of the first semiconductor material.

6. The apparatus of claim any one of claims 1-5, wherein the first semiconductor material is a first of silicon or germanium, or a first SiGe alloy, and wherein the second semiconductor material is a second of silicon or germanium, or a second SiGe alloy.

7. The apparatus of claim 6, wherein the first semiconductor material is silicon and the second semiconductor material is a SiGe alloy.

8. The apparatus of any one of claims 1-7, wherein the RoW of the second semiconductor material is between, and in direct contact with, two of the RoWs of the first semiconductor material.

9. The apparatus of any one of claims 1-8, wherein individual ones of the RoWs of the first semiconductor material within the first stack are substantially co-planar with corresponding ones of the RoWs of the first semiconductor material within the second stack.

10. The apparatus of any one of claims 1-9, wherein:
the first stack comprises a first integer number of RoWs of the first semiconductor material;
the second stack comprises a second integer number of RoWs of the first semiconductor material; and
the second integer number is less than, or equal to, the first integer number.

11. The apparatus of any one of claims 1-10, wherein the RoWs of the first semiconductor material in the second stack comprise a first impurity dopant concentration that is at least two orders of magnitude greater than a second impurity dopant concentration in the RoWs of the first semiconductor material in the first stack.

12. An apparatus, comprising: a transistor structure, comprising:
a first stack of first semiconductor material layers coupled to a pair of terminals comprising an impurity-doped semiconductor material; and
a gate stack comprising a gate insulator and a third terminal comprising a metal, the gate stack adjacent to a sidewall of, and between, individual ones of the first semiconductor material layers; and
a resistor structure, comprising:
a second stack of the first semiconductor material layers coupled between a pair of terminals comprising the impurity-doped semiconductor material, wherein:
the first semiconductor material layers within the second stack have an impurity concentration that is at least two orders of magnitude higher than that of the first semiconductor material layers within the first stack; and
a second semiconductor material layer is between individual ones of the first semiconductor material layers within the second stack.

13. The apparatus of claim 12, wherein:
the first semiconductor material layers comprise a first group IV semiconductor material; and
the second semiconductor material layer comprises a second group IV semiconductor material.

14. The apparatus of claim 13, wherein the first Group IV semiconductor material is substantially pure Si and the second group IV semiconductor material an alloy of Si and Ge.

15. The apparatus of any one of claims 12-14, wherein:
the first stack of first semiconductor material layers comprises at least four of the first semiconductor material layers;
the second stack of first semiconductor material layers comprises at least one the first semiconductor material layers; and
one of the first semiconductor material layers within the second stack is substantially co-planar with an uppermost one of the first semiconductor material layers within the first stack.
